# FASCICULE DE BREVET EUROPEEN

(11) **EP 0 334 433 B1**
(45) Date de publication et mention de la délivrance du brevet: **08.09.1993**
(21) Numéro de dépôt: 89200665.1
(22) Date de dépôt: 16.03.1989
(51) Int. Cl.: C30B 25/12, C30B 25/14, C23C 16/44

(54) **Reacteur d'épitaxie à planétaire**
Epitaxiereaktor mit Planetenbewegung
Planetary reactor for epitaxy

(30) Priorité: 22.03.1988 FR 8803688
(43) Date de publication de la demande: 27.09.1989
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Frijlink, Peter, F-75007 Paris (FR)
(74) Mandataire: Caron, Jean

(56) Documents cités:
- DE-A- 2 218 609
- FR-A- 1 363 449
- FR-A- 2 596 070
- PATENT ABSTRACTS OF JAPAN, vol. 9, no. 145 (C-287)[1868], 20 juin 1985#

## Description

La présente invention concerne un réacteur d'épitaxie pour traiter plusieurs plaquettes de matériau semi-conducteur en les exposant à un courant gazeux réactif, muni d'un support desdites plaquettes, support de type planétaire, c'est-à-dire comportant des moyens pour faire tourner une pluralité de disques d'un mouvement général autour d'un axe central tout en les faisant en outre tourner chacun sur soi même, chacun d'eux portant une plaquette.

Un tel support de plaquettes dit aussi "support d'échantillon", est connu du document FR-A-2 596 070, qui décrit en détail un support, des disques et des moyens pour faire tourner les disques.

Ce document ne traite pas du problème suivant : un tel support présente d'assez grandes dimensions, qui nécessitent une enceinte de réacteur de dimensions correspondantes.

Le document DE-A-2 218 609 décrit un réacteur qui comporte un support planéraire, c'est-à-dire constitué d'un disque principal qui peut tourner, et qui supporte des disques secondaires. Il permet de réaliser le traitement de plusieurs plaquettes sans ouvrir l'enceinte, du fait que le disque principal sert à la manutention des plaquettes : il est mis en rotation pour amener les plaquettes dans l'enceinte d'épitaxie et les en retirer, mais il est arrêté pendant l'opération de croissance épitaxiale. L'enceinte d'épitaxie ne contient qu'une plaquette. Ainsi donc ce réacteur ne permet pas le traitement simultané de plusieurs plaquettes. Du fait que les plaquettes sont traitées les unes après les autres, le cycle de traitement est long, par contre du fait de la dimension réduite réservée à l'épitaxie, ce réacteur fournit sans difficultés une bonne régularité de l'épaisseur des dépôts, et le document ne divulgue que des moyens très succincts en ce qui concerne ce problème.

L'invention fournit un réacteur dont l'enceinte est très compacte et bon marché, et qui permet de traiter plusieurs plaquettes simultanément sans ouvrir l'enceinte tout en permettant d'obtenir une bonne homogénité de l'épaisseur des dépôts.

A cet effet, l'enceinte dans laquelle les gaz réactifs sont en contact avec les plaquettes est constituée d'un corps cylindrique d'axe vertical qui contient l'ensemble du support planétaire et qui l'entoure au plus près, corps cylindrique sur les sections inférieure et supérieure duquel sont appliqués hermétiquement, respectivement un fond constitué d'une plaque, et un couvercle amovible et plat à l'exception de sa partie centrale dans laquelle débouche au moins un conduit relié à une source extérieure de gaz réactif et qui débouche au dessus de la partie centrale du support.

Dans certaines phases opératoires, il faut introduire plusieurs gaz qui sont susceptibles de réagir entre eux très vite. C'est le cas par exemple de l'arsine avec le triethyl-indium. Il convient donc d'éviter de les mélanger à l'avance, et il faut les introduire simultanément mais séparément dans l'enceinte.

A cet effet les gaz réactifs sont amenés par plusieurs entonnoirs concentriques, dont la partie évasée est tournée vers le bas et débouche dans l'enceinte au dessus du support planétaire, et qui sont raccordés, dans leurs parties les plus étroites, chacun avec un tube d'arrivée de gaz.

Cette disposition permet d'obtenir que les flux gazeux ne se mélangent pas trop vite lors de leur mouvement radial vers l'extérieur de l'enceinte, ce qui provoquerait un dépôt granuleux et abondant au centre du réacteur, nuisible malgré la rotation des plaquettes sur elles-mêmes. En outre une grille cylindrique est avantageusement disposée dans l'espace annulaire par lequel l'entonnoir le plus grand débouche dans l'enceinte. Cette grille est par exemple constituée d'ailettes tangentes à la section cylindrique de la grille. De plus, la partie inférieure de la paroi conique qui sépare l'un de l'autre les deux espaces annulaires d'introduction des gaz situés le plus à l'extérieur est avantageusement prolongée par une couronne à peu près plane et horizontale. Toutes ces dispositions coopèrent pour améliorer encore la régularité des dépôts sur toute la surface des plaquettes. En outre, lorsque le réacteur est utilisé pour le dépôt de composés dits III-V, l'entonnoir central est utilisé pour introduire les composés V et l'entonnoir extérieur pour les composés III. Cette caractéristique, jointe à celles exposées plus haut, permet d'obtenir que le gaz portant le composé V soit toujours en excès par rapport aux autres constituants à la surface des plaquettes.

Pour améliorer encore l'homogénéité du flux radial de gaz réactifs, le support planétaire est entouré immédiatement, à l'intérieur de l'enceinte cylindrique, par une couronne faite d'un anneau en quartz muni d'orifices régulièrement disposés le long de sa circonférence, à l'extérieur de laquelle est ménagé un espace annulaire de circulation de gaz.

Un autre avantage important de la disposition selon l'invention est la facilité de chargement/déchargement des plaquettes de semiconducteur à traiter. En effet, le réacteur peut être ouvert par le dessus, offrant un accès direct à l'emplacement des plaquettes. Afin de profiter au maximum de cet avantage et rendre l'opération d'ouverture encore plus rapide, au lieu que le couvercle soit fixé par une série de boulons périphériques, il est appuyé sur le corps cylindrique par un système de vérins, qui permettent de le relever pour le chargement/déchargement du réacteur.

La description qui va suivre, en regard des dessins annexés décrivant des exemples non limitatifs fera bien comprendre comment l'invention peut être réalisée.
La figure 1 est une demi-vue latérale en coupe (selon la ligne AA de la figure 2) d'un réacteur selon l'invention.
La figure 2 est une vue de dessus du même réacteur, avec le couvercle enlevé, à une échelle réduite d'environ moitié par rapport à celle de la figure 1.
La figure 3 est une vue de dessus d'une pièce du réacteur.

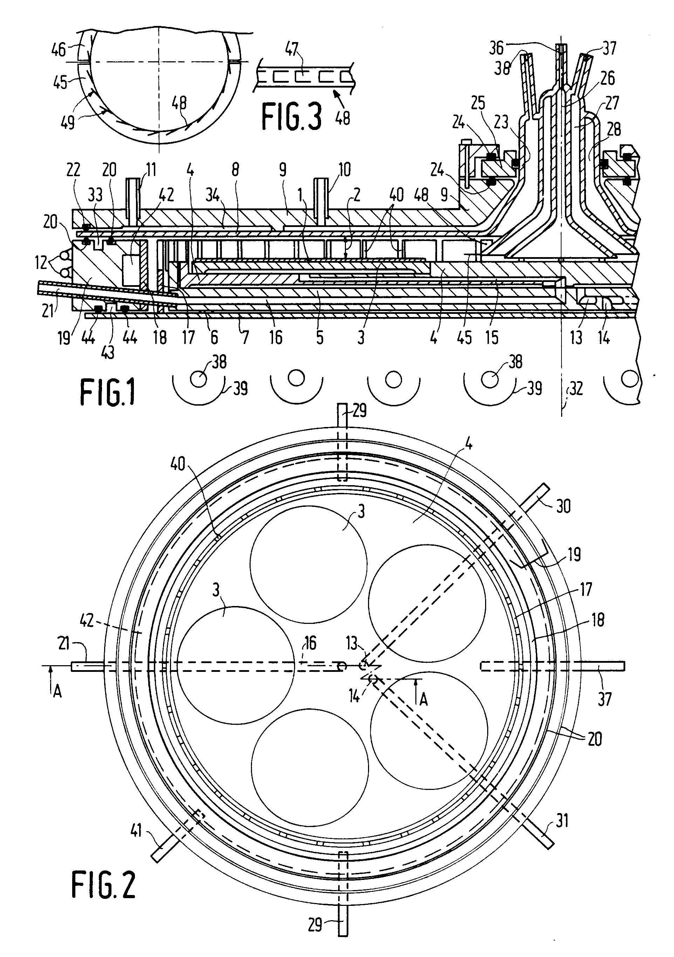

Afin de pouvoir réaliser un dessin à plus grande échelle, la figure 1 ne représente qu'un peu plus de la moitié d'un réacteur. A l'aide de la figure 2, la partie non représentée se déduit aisément à partir des éléments représentés.

Le support des plaquettes est constitué d'un disque fixe 5 en graphite percé de canalisations d'amenée de gaz 13, 14, 16 et dont la partie supérieure est creusée en forme de cuvette. Dans cette cuvette est disposé un disque principal 4 d'environ 25 cm de diamètre qui tourne en sustentation sur un lit de gaz et ce disque porte à son tour plusieurs disques secondaires 3 qui, eux aussi, tournent en sustentation sur un lit de gaz, et sur chacun desquels est posée une plaquette ou tranche de semiconducteur 1. Un tube d'amenée de gaz dont on ne voit que l'extrémité en 13 car il n'est pas dans le plan de la coupe amène le gaz de sustentation (de d'hydrogène) sous le disque principal 4. Un autre tube 16 débouche au centre du plateau fixe 5 en face d'une extrémité d'un conduit 15 qui est à l'intérieur du disque principal tournant 4 et qui débouche sous le disque secondaire 3.

Dans les disques 4 et 5 sont creusées des rigoles en forme de spirale qui provoquent une composante de rotation du gaz entraînant la rotation des disques supportés. Sous chaque disque rotatif est prévue une rigole qui collecte les gaz et les renvoie vers le disque inférieur. Ceci est décrit en détail dans le document FR-A-2 596070, particuliérement par la description de figures 7a et 7b, qui doit être considéré comme faisant partie de la présente description, à titre d'exemple de réalisation du support.

La dimension du disque principal permet de loger par exemple au choix 5 disques secondaires portant chacun une plaquette de 7,62 cm de diamètre ou 7 disques secondaires portant chacun une plaquette de 5,08 cm de diamètre. Le disque intermédiaire a une épaisseur d'environ 5mm, le disque principal une épaisseur d'environ 12mm, et avec le disque support fixe l'épaisseur totale est d'environ 28mm. Toutes ces pièces sont réalisées en graphite.

L'enceinte du réacteur est constituée d'un corps cylindrique 19 d'axe vertical 32 de section circulaire sur lequel sont appliqués hermétiquement un couvercle 8 et un fond 7 sur lesquels on reviendra plus loin. Ce corps 19 entoure au plus près les disques 4 et 5, de façon à limiter au maximum le volume à chauffer et le volume des gaz réactifs nécessaires. La hauteur du corps 19 est choisie de manière à laisser au-dessus du support en graphite 3, 4, 5 un espace 2 de hauteur appropriée pour le passage des gaz réactifs. C'est dans cet espace que les plaquettes sont en contact avec les gaz réactifs.

Ce corps est refroidi par un serpentin constitué de tubes 12 qui lui sont soudés et dans lequel circule de l'eau. Le corps est réalisé en acier inoxydable. Il comporte une gorge intérieure 42 qui en fait le tour et qui est fermée par une paroi cylindrique 18 en quartz qui recouvre toute la surface interne du corps cylindrique. De l'hydrogène est amené dans la gorge 42 par un tube 41 (figure 2) et pénètre dans l'enceinte en fuyant par l'intervalle entre le corps 19 en acier et la couronne 18 en quartz, de façon à éviter que des produits de réaction n'y pénètrent et salissent le corps 19. Le gaz de sustentation pour le système support de plaquettes est amené par un tube 21 qui traverse le corps cylindrique et la couronne 18 et pénètre dans le bloc de graphite 5.

Le fond du réacteur est constitué par une simple plaque de quartz circulaire 7 dont l'épaisseur est d'environ 4 mm. L'étanchéité est assurée par 2 joints toriques 44 entre lesquels est creusée une gorge 43 dans laquelle on fait le vide.

Le système support de plaquettes est posé sur ce fond 7 par l'intermédiaire de cales 6 en graphite, qui ménagent un espace pour l'évacuation des gaz de sustentation. En outre, un tube débouchant en 14 et dont l'orifice est tourné vers le dessous du disque fixe 5 injecte de l'hydrogène dans cet espace afin d'éviter que les gaz réactifs ne puissent y parvenir et y réaliser des dépôts.

Sous le fond 7 sont disposées des lampes infrarouges 38, munies de réflecteurs 39, fournissant un rayonnement infrarouge qui traverse le fond 7 et chauffe le support de graphite 5. L'utilisation d'une pluralité de lampes permet de moduler leur puissance relative pour obtenir une régularité parfaite du chauffage depuis le centre jusqu'à l'extérieur du disque.

Le couvercle est constitué d'un disque de quartz 8 dont l'épaisseur est d'environ 4mm, appliqué sur des joints toriques 20 entre lesquels est prévue une gorge 33 comme la gorge 43 à la partie inférieure. Ce disque est globalement plat, c'est à dire qu'il est plat à l'exception de son centre qui est relevé en forme d'entonnoir 28. Du gaz peut être amené dans cet entonnoir par le tube 38. A l'intérieur de l'entonnoir 28 sont prévus deux autres volumes 26 et 27 concentriques dont la partie inférieure est en forme d'entonnoir avec la partie évasée vers le bas. Chacun des volumes 26 et 27 communique avec une source de gaz par un tube respectivement 36, 37. Cet ensemble de trois entonnoirs concentriques est réalisé en quartz et l'entonnoir extérieur est réalisé d'une seule pièce avec le couvercle 8. La partie inférieure des pièces 26 et 27 est située à environ 2mm au-dessus du disque principal 4. Le tube intérieur 36 permet d'amener par exemple de l'arsine AsH₃ prédilué dans l'hydrogène ; le second conduit 37 amène par exemple de l'hydrogène, et le conduit extérieur 38 peut amener un mélange de corps organo-métalliques dilués dans de l'hydrogène.

Pour éviter que la distribution du flux, égale dans toutes les directions dans le plan horizontal, ne soit instable, une grille cylindrique 48 est placée dans l'espace annulaire par lequel l'entonnoir 28 débouche dans l'enceinte. Cette grille est représentée isolément sur la figure 3, où elle est vue de dessus. A droite de la figure est indiqué aussi un morceau de grille, vu de côté : c'est une bande 48 plate en feuillard de molybdène dans laquelle sont réalisées au laser des découpes en forme de U qui créent chacune une languette 47. Lorsque la bande est enroulée pour former un cylindre, les languettes restent plates et tangentes à la section du cylindre obtenu, comme indiqué en 49. Elles forment des ailettes qui imposent au gaz une vitesse de sortie à peu près tangentielle au cylindre . Du fait que chaque ailette est balayée à l'extérieur par le gaz frais sortant de l'ailette précédente, il ne s'y forme pas de dépôt salissant.

En outre, la partie inférieure de la paroi conique qui sépare l'un de l'autre les deux espaces annulaires 27, 28 d'introduction des gaz situés le plus à l'extérieur est prolongée par une couronne à peu près plane et horizontale. Cette couronne est réalisée en mobybdène et en deux parties 45, 46 pour en faciliter le montage. Elle peut être fixée par exemple à la grille 48 par tout moyen connu. On se rend compte en observant cette couronne 45 sur la figure 1, qu'elle sépare l'un de l'autre les flux de gaz sortant des volumes 28 d'une part, et 26, 27 d'autre part, retardant leur mélange et rendant horizontale leur vitesse, afin d'éviter les turbulences.

Cette couronne 45 pourrait aussi être constituée par un aplatissement du bord en quartz de la paroi d'entonnoir située entre les volumes 27 et 28.

Le couvercle 8 est maintenu par une pièce métallique 9 qui l'appuie contre le corps 19. Entre la pièce métallique 9 et le disque 8 est ménagé un espace 34 que l'on peut, pour régler la température du couvercle, remplir de gaz au moyen de tuyaux 10, 11 et dont l'étanchéité est réalisée au moyen des joints toriques 22, 23, 24. La pièce annulaire 25 pouvant coulisser légèrement par rapport à la pièce 9 est destinée à éviter de briser le couvercle en quartz lors du montage. La pièce métallique 9 est refroidie par des moyens non représentés, qui peuvent être par exemple des tubes d'eau analogues aux tubes 12, ou bien des passages creux ménagés dans la pièce et remplis d'eau.

L'ensemble des pièces constituant le couvercle peut être soulevé pour accéder à l'intérieur du réacteur. Un système est prévu pour appuyer cet ensemble sur le corps 19 et aussi pour le soulever. Il n'est pas représenté pour ne pas compliquer la figure. Il peut être réalisé facilement par tous les moyens connus de la mécanique. A titre d'exemple la pièce 9 peut être munie de manchons à billes coulissant autour de tubes verticaux et permettant donc un mouvement de translation verticale, mouvement qui est commandé par un ou plusieurs vérins hydrauliques.

Pour augmenter l'homogénité de la répartition des mélanges gazeux le long des cercles d'axes 32, le dispositif porte-plaquettes est entouré d'une couronne en quartz 17 qui est munie d'orifices, ici des fentes verticales 40 régulièrement disposées tout le long de sa circonférence. Entre cette couronne 17 et la couronne 18 existe un espace annulaire dans lequel débouchent deux tubes 29 diamétralement opposés (figure 2) qui permettent l'évacuation des gaz réactifs.

Sur la figure 2, qui représente le réacteur couvercle enlevé on peut voir la disposition des différents tubes traversant le corps 19 : le tube 21 d'amenée des gaz de sustentation qui débouche dans le bloc de graphite 5,le tube 31 débouchant en 14 pour débiter du gaz sous l'ensemble support de plaquettes, le tube 30 qui débouche en 13 pour fournir le gaz de sustentation du disque principal 4, le tube 16 creusé dans la partie fixe du support de plaquettes et qui amène le gaz destiné aux disques secondaires, le tube 41 amenant du gaz dans la gorge annulaire 42, les tubes 29 d'évacuation des gaz réactifs, et un tube 37 fermé à son extrémité qui pénètre dans la partie fixe du support de plaquettes et permet l'introduction d'un thermocouple de mesure de la température. Le disque principal représenté ici porte cinq disques secondaires 3 de 7,62cm de diamètre.

A titre de variante, la section du corps cylindrique 19 pourrait aussi, par exemple, être un carré au lieu d'un cercle, ce qui ne changerait pas le comportement des flux gazeux pourvu que l'on conserve la couronne extérieure 18.

## Revendications

1. Réacteur d'épitaxie pour traiter plusieurs plaquettes de matériau semi-conducteur en les exposant à un courant gazeux réactif, muni d'un support (5, 4, 3) desdites plaquettes, support de type planétaire, c'est-à-dire comportant des moyens pour faire tourner une pluralité de disques (3) d'un mouvement général autour d'un axe central tout en les faisant en outre tourner chacun sur soi même, chacun d'eux portant une plaquette (1), caractérisé en ce que l'enceinte dans laquelle les gaz réactifs sont en contact avec les plaquettes est constituée d'un corps cylindrique (19) d'axe vertical (32) qui contient l'ensemble du support planétaire (4) et qui l'entoure au plus près, corps cylindrique sur les sections inférieure et supérieure duquel sont appliqués hermétiquement, respectivement un fond (7) constitué d'une plaque, et un couvercle (8) amovible et plat à l'exception de sa partie centrale dans laquelle débouche au moins un conduit (26) relié à une source extérieure de gaz réactif et qui débouche au dessus de la partie centrale du support.

2. Réacteur selon la revendication 1, caractérisé en ce que les gaz réactifs sont amenés dans l'enceinte par plusieurs entonnoirs concentriques (26, 27, 28) dont la partie évasée est tournée vers le bas, qui débouchent dans l'enceinte au dessus du support planétaire (4), et qui sont raccordés, dans leurs parties les plus étroites, chacun avec un tube (36, 37, 38) d'arrivée de gaz.

3. Réacteur selon la revendication 2, caractérisé en ce qu'une grille cylindrique (48) est disposée dans l'espace annulaire par lequel l'entonnoir le plus grand (28) débouche dans l'enceinte.

4. Réacteur selon la revendication 3, caractérisé en ce que la grille est constituée d'ailettes (49) tangentes à la section cylindrique de la grille.

5. Réacteur selon l'une quelconque des revendications 2 à 4, caractérisé en ce que la partie inférieure de la paroi conique qui sépare l'un de l'autre les deux espaces annulaires par lesquels les entonnoirs (27, 28) débouchent dans l'enceinte, et qui sont situés le plus à l'extérieur, est prolongée par une couronne à peu près plane et horizontale (45, 46).

6. Réacteur selon l'une quelconque des revendication 2 à 5, pour l'épitaxie de composés III-V, caractérisé en ce que l'entonnoir central (26) est utilisé pour introduire les composés V et l'entonnoir extérieur (28) pour les composés III.

7. Réacteur selon l'une des revendications 3 à 6, caractérisé en ce que le couvercle (8) est un disque de quartz, et en ce qu'il est fait d'une seule pièce avec l'entonnoir (28) le plus à l'extérieur.

8. Réacteur selon l'une quelconque des revendications précédentes, caractérisé en ce que le support planétaire est entouré immédiatement, à l'intérieur de l'enceinte cylindrique, par une couronne (17) faite d'un anneau en quartz muni d'orifices (40) régulièrement disposés le long de sa circonférence, à l'extérieur de laquelle est ménagé un espace annulaire de circulation de gaz.

9. Réacteur selon l'une quelconque des revendications précédentes, caractérisé en ce que le couvercle est appuyé sur le corps cylindrique par un système de vérins, qui permettent de le relever pour le chargement/déchargement du réacteur.

## Claims

1. An epitaxial growth reactor for processing a plurality of wafers of a semiconductor material by exposing them to a reactive gas flow, provided with a planetary support (5, 4, 3) for the said wafers, i.e. a support comprising means for causing a plurality of discs (3) to rotate in a joint movement around an axis while at the same time causing them to rotate around themselves, each of these discs carrying a wafer (1), characterized in that the chamber in which the reactive gases are in contact with the wafers during growth is formed by a cylindrical body (19) having a vertical axis (32) which contains the assembly of the planetary support (4) and which substantially surrounds said assembly, on the upper and lower sections of which cylindrical body are provided in a hermetically sealing manner, respectively, a bottom (7) formed by a plate and a removable cover (8) which is flat, with the exception of the central portion thereof, into which at least one conduit (26) issues connected to a source of reactive gas and issuing above the central portion of the support.

2. A reactor as claimed in Claim 1, characterized in that the reactive gases are fed into the chamber through several concentric funnels (26, 27, 28) whose flared portions face downwards and issue into the chamber above the planetary support (4), and whose narrowest portions are connected to respective gas supply tubes (36, 37, 38).

3. A reactor as claimed in Claim 2, characterized in that a cylindrical grid (48) is located in the annular space through which the largest funnel (28) issues into the chamber.

4. A reactor as claimed in Claim 3, characterized in that the grid is formed by ribs (49) which extend tangentially to the cylindrical cross-section of the grid.

5. A reactor as claimed in anyone of the Claims 2 to 4, characterized in that the lower portion of the conical wall which separates from each other the two outermost annular gas inlet, through which the funnels (27, 28) issue into the chamber, is extended by a substantially flat and horizontal rim (45, 46).

6. A reactor as claimed in any one of the Claims 2 to 5 for the epitaxy of III-V compounds, characterized in that the central funnel (26) is used to introduce the V compounds and the outer funnel (28) is used to introduce the III compound.

7. A reactor as claimed in any one of the claims 3 to 6, characterized in that the cover (8) is a quartz disc, and that it is constructed as an integral whole with the outermost funnel (28).

8. A reactor as claimed in any one of the preceding Claims, characterized in that the planetary support is immediately surrounded, at the inside of the cylindrical chamber, by a rim (17) made of a quartz ring provided with apertures (40) which are distributed uniformly along its circumference, at the exterior side of which an annular gas circulation space is made.

9. A reactor as claimed in any one of the preceding Claims, characterized in that the cover is secured on the cylindrical member by a system of jack which render it possible to lift the cover for loading/unloading the reactor.

## Patentansprüche

1. Epitaxiereaktor zum Bearbeiten einer Anzahl von Scheiben aus einem Halbleitermaterial durch Exponieren an einer reaktiven gasartigen Strömung, mit einem Scheibenträger (5, 4, 3) vom Typ Planetenträger, d.h. einem Träger mit Mitteln zum Auslösen einer Drehung in einer allgemeinen Bewegung um eine Achse durch eine Anzahl von Platten (3), während außerdem ihre Rotation um die eigene Achse ausgelöst wird, wobei jede Platte beim Zuchten eine Scheibe (1) trägt, dadurch gekennzeichnet, dal der Ofen, in dem die reaktiven Gase mit den Scheiben in Kontakt sind, aus einem zylindrischen Körper (19) mit vertikaler Achse (32) zusammengesetzt ist, der die Einheit des Planetenträgers (4) enthält und ihn fast ganz umgibt, wobei die unteren und oberen Abschnitte des zylindrischen Körpers hermetisch angeordnet werden, aus einem Boden (7), der aus einer Platte besteht bzw. aus einem abnehmbaren und mit Ausnahme seines Zentralteils flachen Deckel (8) zusammengesetzt, in den wenigstens ein Kanal (26) mündet, der mit einer externen Reaktivgasquelle verbunden ist und über dem Zentralteil des Trägers ausmündet.

2. Reaktor nach Anspruch 1, dadurch gekennzeichnet, daß die reaktiven Gase durch verschiedene konzentrische Trichter (26, 27, 28) zugeführt werden, deren aufgeweiteter Teil nach unten gekehrt ist und in den Ofen über dem Planetenträger (4) mündet, und die in ihren schmaleren Teilen mit je einem Gaseintrittsrohr (36, 37, 38) verbunden sind.

3. Reaktor nach Anspruch 2, dadurch gekennzeichnet, daß ein zylindrisches Gitter (48) im ringförmigen Raum angeordnet, durch den der größte Trichter (28) in den Ofen mündet.

4. Reaktor nach Anspruch 3, dadurch gekennzeichnet, daß das Gitter aus Schaufeln (49) besteht. die in bezug auf den zylindrischen Teil des Gitters tangential verlaufen.

5. Reaktor nach einem der Ansprüche 2 bis 4, dadurch gekennzeichnet, daß der untere Teil der konischen Wand, der die beiden ringförmigen Räume von einander trennt, in die die Trichter (27, 28) in den Ofen münden, un die sich möflichst weit nach außen befinden, sich in einen nahezu flachen und horizontalen Rand (45, 46) fortsetzt.

6. Reaktor nach einem oder mehreren der Ansprüche 2 bis 5 für Epitaxie der Verbindungen III-V, dadurch gekennzeichnet, daß der zentrale Trichter (26) zum Eingeben der Verbindungen V und der äußere Trichter (28) für die Verbindungen III verwendet werden.

7. Reaktor nach einem oder mehreren der Ansprüche 3 bis 6, dadurch gekennzeichnet, daß der Deckel (8) eine Quarzscheibe ist, und daß er aus einem Stück besteht, wobei der Trichter (28) möglichst weit nach außen angeordnet ist.

8. Reaktor nach einem oder mehrern der vorangehenden Ansprüche, dadurch gekennzeichnet, daß der Planetenträger im Inneren des zylindrischen Ofens unmittelbar von einem Rand (17) umgeben ist, der ein Quarzring ist, der auf seinem Umfang mit in regelmäßigen Abständen voneinander angebrachten Öffnungen (40) versehen ist, wobei der Außenseite des Umfangs mit einem ringförmigen Gasumlaufraum versehen ist.

9. Reaktor nach einem oder mehrern der vorangehenden Ansprüche, dadurch gekennzeichnet, daß der Deckel mittels eines Windensystems auf dem Zylinderkörper angebracht wird, wobei die Winden das Abheben des Deckels zum Laden/Entladen des Reaktors ermöglichen.
